(19) Europäisches Patentamt
European Patent Office
Office européen des brevets

(11) **EP 1 215 503 B2**

(12) **NEUE EUROPÄISCHE PATENTSCHRIFT**

(45) Veröffentlichungstag und Bekanntmachung des Hinweises auf die Entscheidung über den Einspruch:
**01.08.2007 Patentblatt 2007/31**

(45) Hinweis auf die Patenterteilung:
**09.02.2005 Patentblatt 2005/06**

(21) Anmeldenummer: **01120937.6**

(22) Anmeldetag: **31.08.2001**

(51) Int Cl.:
**G01R 19/00** (2006.01)     **H02P 6/08** (2006.01)

(54) **Strom- und Leistungsfaktormessung**

Measuring current and power factor

Mesure de courant et de facteur de puissance

(84) Benannte Vertragsstaaten:
**DE FR GB IT**

(30) Priorität: **18.12.2000 DE 10063054**

(43) Veröffentlichungstag der Anmeldung:
**19.06.2002 Patentblatt 2002/25**

(73) Patentinhaber: **WILO AG**
**44263 Dortmund (DE)**

(72) Erfinder:
• **Kiffer, Björn**
**44137 Dortmund (DE)**
• **Tolksdorf, Frank**
**58675 Hemer (DE)**
• **Heinrich, Klaus**
**44227 Dortmund (DE)**

(74) Vertreter: **COHAUSZ DAWIDOWICZ**
**HANNIG & SOZIEN**
**Patentanwälte**
**Schumannstrasse 97-99**
**40237 Düsseldorf (DE)**

(56) Entgegenhaltungen:
**EP-A- 0 051 780        EP-A- 0 370 254**
**DE-A- 3 540 182        DE-A- 19 860 446**
**US-A- 5 486 747        US-A- 5 969 958**

• **GREEN T C ET AL: "Derivation of motor line-current waveforms from the DC-link current of an inverter" IEE PROCEEDINGS B (ELECTRIC POWER APPLICATIONS), JULY 1989, UK, Bd. 136, Nr. 4, Seiten 196-204, XP002255849 ISSN: 0143-7038**
• **"High-Efficiency Drive due to Power Factor Control of a Permanent Magnet Synchronous Motor"; Y. Nakamura, T. Kudou, F. Ishibashi, S. Hibino; Seiten 263-268, 0-7803-0485-3/92 in IEEE 1992, XP000340798**

EP 1 215 503 B2

**Beschreibung**

Die vorliegende Erfindung betrifft ein Verfahren zur einmaligen Ermittlung einer Korrelationsfunktion für die Bestimmung der Amplitude und/oder der Phase des Stromes am Ausgang eines insbesondere durch einen Synchronmotor belasteten Pulsweiten modulierten (PWM)-Umrichterkreises, der einen vor einem Wechselrichter liegenden Gleichstromkreis aufweist, wobei der Wechselrichter mindestens zwei Schalter aufweist, die in geschlossener Schaltphase den Strom auf eine Ausgangsleitung durchschalten. Die Erfindung betrifft zudem ein Verfahren zur Leistungsfaktorregelung eines Elektromotors basierend auf der Messung des Stromes am Ausgang des den Motor versorgenden PWM-Umrichterkreises.

Aus DE 3540182 A1 und GREEN, T. C. ET AL: "Derivation of motor line-current waveforms from the DC-link current of an inverter", IEE PROCEEDINGS B (ELECTRIC POWER APPLICATIONS), July 1989, UK, Bd. 136, Nr. 4, Seiten 196-204, XP002255849, ISSN: 0143-7038 ist ein Verfahren zur Bestimmung der Amplitude und/oder der Phase des Stromes am Ausgang eines insbesondere durch einen Synchronmotor belasteten PWM-Umrichterkreises bekannt.

Die Strommessung am Ausgang derartiger PWM-Umrichterkreise ist generell bekannt und wird bislang durch eine direkte Messung beispielsweise über einen Meßwiderstand ("Shunt") in einer Ausgangsleitung durchgeführt. Eine solche Messung kann insbesondere dazu verwendet werden, den Leistungsfaktor, also die Phasenverschiebung zwischen der erregenden Wechselspannung und dem von ihr erzeugten Strom, zu messen. Seit kurzer Zeit sind insbesondere Verfahren zur Leistungsregelung von Synchronmotoren erdacht, die sich einer Messung des Leistungsfaktors bedienen. Diese Verfahren gehen von der Erkenntnis aus, daß der Leistungsfaktor eine definierte Abhängigkeit vom Betriebspunkt, also von der Belastung und von der Motordrehzahl, aufweist. Bei dem Verfahren wird die Phasenverschiebung zwischen der Motorspannung und dem Motorstrom je nach der Drehzahl und/oder der aktuellen Belastung durch Änderung der Spannung am Ausgang des PWM-Umrichters (Strangspannung) auf den jeweils erforderlichen Wert eingestellt.

Die Leistungsfaktormessung bei dem erwähnten Regelverfahren wird bislang über eine Strommesung am Ausgang des Wechselrichters realisiert. Dabei wird der Zeitpunkt des Strom-Nulldurchgangs unter Zugrundelegung des zeitlichen Verlaufes der Wechselspannung und des gemessenen Betriebspunktes des Motors vorhergesagt. Zu diesem Zeitpunkt kann der Strom beispielsweise anhand der rückinduzierten Spannung (Back-EMF) ohne einen bemerkenswerten Eingriff in den Gleichlauf des Motors bestimmt und seine Abweichung vom Sollwert "Null" gemessen werden. Diese Abweichung des Stromes vom Sollwert repräsentiert die momentane Belastung des Motors und die Amplitude und/oder die Frequenz der Wechselspannung kann entsprechend angepaßt werden, wobei der Istwert des Stromes an den Sollwert angenähert wird.

Nachteilig an dem Verfahren ist jedoch, daß der Eingriff letztendlich nicht völlig ohne eine Störung des Motorgleichlaufes geschieht. Diese, wenn auch geringe Störung, kann aber zu Geräuschen führen, die gerade beim Antrieb einer Pumpe, insbesondere einer Heizungspumpe, mit erheblichen Nachteilen einhergeht. Zudem ist nachteilig, daß es teurer und anfälliger Sensoren zur Messung der Drehzahl bedarf.

Aufgabe der vorliegenden Erfindung ist es nunmehr, zunächst ein einfach zu realisierendes und dabei zuverlässiges Verfahren zur einmaligen Ermittlung einer Korrelationsfunktion für die Bestimmung des Stromes, insbesondere des Leistungsfaktors, am Ausgang eines PWM-Umrichters zu schaffen. Eine weitere Aufgabe der Erfindung liegt darin, ein Verfahren zur Leistungsfaktorregelung eines Elektromotors zu schaffen, das bei einfacher und kostengünstiger Realisierbarkeit einen gleichmäßigen und geräuscharmen Motorlauf ermöglicht und eine hohe Zuverlässigkeit des Motors gewährleistet.

Diese Aufgaben werden durch ein Verfahren nach Anspruch 1 und den Einsatz des Verfahrens nach Anspruch 11 gelöst.

Der Erfindung liegt die Erkenntnis zu grunde, daß der Strom im Gleichrichter- oder Zwischenkreis mit der Spannung respektive dem Strom im Ausgangskreis korreliert. Unter Kenntnis der Korrelationsfunktion ist es möglich den Strom im Ausgangskreis durch Messung des Stromes im Gleichrichterkreis zu bestimmen. Die Messung des Zwischenkreisstromes ist wesentlich einfacher und mit einer Messung des Spannungsabfalls an einem im Gleichrichterkreis befindlichen Shunt zu bewältigen. Die besonderen Vorteile der Erfindung ergeben sich dabei daraus, daß keinerlei Eingriff in den Ausgangskreis notwendig ist und es im Falle der Leistungsfaktorregelung eines Elektromotors nicht zu Störungen im Gleichlauf des Motors kommen kann. Die Strombestimmung kann dabei einerseits an singulären Meßpunkten als aktuelle Absolutmessung oder andererseits als kontinuierliche Beobachtung des Stromverlaufes, beispielsweise zur Bestimmung des für die Leistungsfaktorregelung benutzten Strom-Nulldurchgangs, eingesetzt werden.

Im Falle der Absolutmessung muß zunächst die Korrelationsfunktion ermittelt werden, die den Zusammenhang zwischen dem Meßwert des Stromes im Gleichspannungskreis und dem zu errechnenden Strom am Ausgang darstellt. Ist dieser Funktion bekannt und insbesondere in einem digitalen Speicher gespeichert, so können einzelne Meßwerte durch rechnerische Anwendung der Funktion umgewandelt werden. Die Korrelationsfunktion muß dabei nur einmal ermittelt werden, was einer Initialisierung und Eichung der späteren Messungen entspricht. Sie geschieht nach dem Schema, daß der Strom im Gleichstromkreis über einen mehrere Schaltphasen umfassenden Zeitraum gemessen und registriert wird. Aus der Beobachtung des registrierten Stromverlaufes kann auf eine nachfolgend zu erklärende Weise eine Verlaufscharakteristik abgeleitet werden. Die Charakteristik ist dabei ein Pendant des tatsächlichen Stromes, wie er im Ausgangskreis zu messen wäre und gleicht im Idealfall in Phase und Amplitude dem tatsächlichen Strom. Der Zusammenhang zwischen der Charakteristik und dem tatsächlichen Ausgangsstrom bildet die Grundlage zur Bestimmung der Korrelationsfunktion. Die Absolutmessung erfolgt dann derart, daß der Strom im Gleichstromkreis während des Betriebes des PWM-Umrichterkreises im Intervall zwischen zwei PWM-Pulsen gemessen wird und daß aus dem aktuellen Meßwert über die Korrelationsfunktion auf den Strom am Ausgang geschlossen wird.

Im Falle der (quasi) kontinuierlichen Relativmessung, wie sie für die Regelung benötigt wird, bedarf es im einfachsten Fall lediglich einer entsprechenden Filterung des registrierten Stromverlaufes, um daraus die Verlaufscharakteristik zu extrahieren. Insbesondere müssen lediglich die durch das Durchschalten des Stromes auf die Ausgänge entstehenden Stromspitzen ausgeblendet zu werden. Der Verlauf des Stromes zwischen den Spitzen entspricht dann der erwünschten Charakteristik, die u. U. direkt mit dem Ausgangsstrom gleichgesetzt werden kann. Bei der kontinuierlichen Messung wird der Strom am Augang dadurch bestimmt, daß während des Betriebes des PWM-Umrichterkreises kontinuierlich der Strom im Gleichstromkries gemessen und aus dieser Messung unter Einbeziehung der Korrelationsfunktion auf den Ausgangsstrom oder insbesondere auf dessen Phasenlage geschlossen wird. Die Messung der Phasenverschiebung kann dann zur Bestimmung des Leistungsfaktors im Ausgangskreis herangezogen werden, der die Grundlage eines Regelungsverfahrens für Elektromotoren bildet. Für diese Regelung ist es wie noch zu beschreiben sein wird, besonders vorteilhaft, aus der Verlaufscharakteristik den Nulldurchgang des Stromes im Ausgangskreis zu bestimmen.

Sowohl im Fall der "Absolutmessung" als auch im Fall der "Relativmessung" wird zunächst der Strom im Gleichstromkreis über einen mehrere Schaltphasen umfassenden Zeitraum gemessen und registriert. Aus dem Stromverlauf, insbesondere aus der Änderung des Stromes zwischen den Durchschaltphasen, wird eine Verlaufscharakteristik und daraus eine Korrelationsfunktion ermittelt, über die der Strom am Ausgang bestimmbar ist. Sollte die Korrelationsfunktion nicht gleich 1 sein oder einem anderen einfachen Faktor entsprechen, so ist es vorteilhaft, sie zur weiteren Verarbeitung in einem digitalen Speicher zu speichern.

In einer besonders einfachen Ausführungsform der Erfindung wird der Strom im Gleichstromkreis auf bekannte Weise über den Spannungsabfall an einen Shunt gemessen. Besonders einfach und damit vorteilhaft ist es, den gemessenen Stromverlauf analog mittels eines Bandpaß zu filtern und das Ergebnis der Filterung der Verlaufscharakteristik direkt gleichzusetzen. Durch den Bandpaß werden die Stromspitzen geglättet und es ergibt sich der in der Frequenz der zu erzeugenden Wechselspannung oszillierende Strom im Gleichstromkreis. An diesem kann eine Bestimmung des Leistungsfaktors vorgenommen werden. In einer besonders vorteilhaften weil flexiblen Ausführungsform werden die Meßwerte mittels eines Analog/ Digital Wandlers (ADC) in digitale Werte umgewandelt, die in einem Speicher registriert werden. Ist der Stromverlauf digital aufgezeichnet, so ist es auf einfache Weise möglich, mit einer rechnerischen Filterfunktion, insbesondere mit einem Mittelwertfilter, die Verlaufscharakteristik zu bestimmen. Die digitale Aufzeichnung des Stromverlaufes bietet dabei eine hohe Flexibilität im Hinblick auf die nachfolgende "rechnerische" Filterung. Einfache Funktionen, wie beispielsweise der Mittelwertfilter, lassen sich durch einen handelsüblichen Mikroprozessor realisieren, ohne daß dessen Kapazität durch die Rechnung sonderlich eingeschränkt wird. Je nach Bedarf sind jedoch auch komplexere und damit aufwendigere Filteralgorithmen möglich.

Die Strommessung ist dabei nicht auf den Einsatz in Wechselrichterkreisen beschränkt, mit denen Elektromotoren versorgt werden. Sie kann bei Wechselrichtern generell eingesetzt werden. Besonders vorteilhaft läßt sie sich jedoch im Rahmen der Leistungsfaktorregelung eines Elektromotors, insbesondere eines permanenterregten Synchronmotors, einsetzen, bei dem die Statorwicklung über eine Ausgangleitung eines PWM-Umrichterkreises versorgt wird. Die Regelung funktioniert dann nach dem folgenden Prinzip: Zunächst wird die Abhängigkeit zwischen den durch Drehzahl und/ oder Belastung definierten Betriebspunkten und der entsprechenden Phasenverschiebung ermittelt und der funktionale Zusammenhang in einem der Regelung zur Verfügung stehenden Speicher niedergelegt wird. Aus der ermittelten Abhängigkeit ergibt sich für jeden Betriebspunkt ein ein Sollwert für den Nulldurchgang des Ausgangsstromes. Im Rahmen der Regelung wird einerseits die aktuelle Drehzahl des Motors ermittelt und andererseits anhand der gemessenen Verlaufscharakteristik des Stromes im Gleichstromkreis der Istwert vom Nulldurchgang des Ausgangsstromes, der einer Phasenverschiebung respektive einem Zeitpunkt entspricht, bestimmt. Der entsprechende Sollwert des Nulldurchgangs ist aus der gespeicherten Abhängigkeit bekannt. Zur Angleichung von Ist- und Sollwert wird die Amplitude der Wechselspannung verändert. Die Versorgung durch den PWM-Gleichrichter wird somit entsprechend der Belastung nachgeregelt.

Das Verfahren beruht somit letztendlich auf einer Leistungsfaktorregelung, bei der die Phasenverschiebung zwischen der Motorspannung und dem Motorstrom je nach der Drehzahl und/oder der aktuellen Belastung auf den jeweils erforderlichen Wert eingestellt werden. Der Leistungsfaktor gibt Aussage darüber, wie sich EMK, Motorspannung und Motorstrom im jeweiligen Betriebspunkt verhalten. Eine Aussage über die genaue Position des Rotors ist mit einer längeren Austastphase möglich und könnte in besonderen Fällen für einen anderen Typ von Regelung eingesetzt werden. In einer besonders vorteilhaften Ausführungsform wird der funktionale Zusammenhang zwischen der Drehzahl und der Phasenverschiebung zudem noch in Abhängigkeit der Ausgangsleistung ermittelt und gespeichert. Wie von anderen Regelungen bekannt, kann es auch im vorliegenden Fall vorteilhaft sein, Grenzwerte vorzugeben, innerhalb derer sich die ermittelte Stromstärke befinden muß. Bei einem Überschreiten der Grenzwerte können Maßnahmen, wie ein Aussetzen und Neustarten der Ansteuerung vorgesehen werden.

Die wesentlichen Vorteile der Erfindung liegen einerseits in der einfachen und kostengünstigen Realisierung des Verfahrens. So läßt sich das Verfahren mit den ehedem in der Steuerelektronik eines Elektromotors vorhandenen Komponenten durchführen. In seiner Einfachheit zeichnet sich das Regelverfahren durch eine hohe Zuverlässigkeit aus. Andererseits ist es besonders vorteilhaft, daß die Laufruhe des Motors durch die Regelung nicht gestört wird. Mit dem Verfahren wird ein sicherer Betrieb des Motors in seinem optimalen Wirkungsgrad über die gesamte Kennlinie gewährleistet, wobei unterschiedliche Drehzahlen und mögliche Lastschwankungen berücksichtigt werden.

Die Erfindung wird anhand der Figuren 1 bis 5 dargestellt und im folgenden näher beschrieben. Es zeigen:

Figur 1:    ein Schema eines Umrichters,

Figur 2:    einen Dreiphasen-Sinus und des Zwischenkreisstrom (theoretisch),

Figur 3:    Schaltzustände,

Figur 4:    gemessene Schaltzustände und

Figur 5:    Zündimpulse, Zwischenkreisstrom und Strangstrom

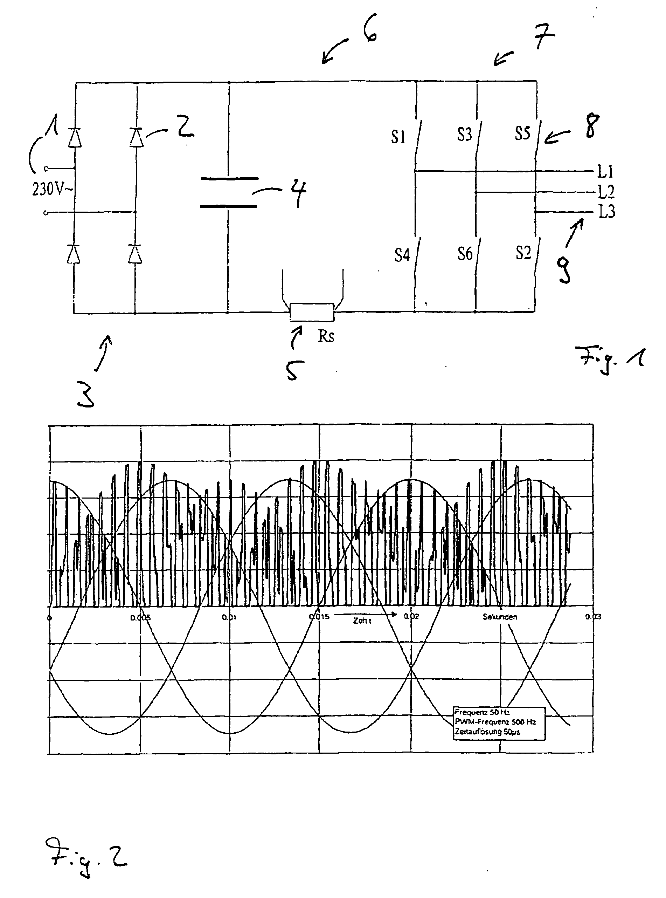

In Figur 1 ist ein Umrichter dargestellt, der von einer Wechselspannung aus dem Netz 1 gespeist wird und der einen in diesem Fall vier Dioden 2 aufweisenden Gleichrichterkreis (Eingangsgleichrichter) 3 hat. Außerdem weist der Umrichter einen Zwischenkreiskondensator 4 und einen Shunt 5 im Gleichstrom- oder Zwischenkreis 6 auf, wobei der Gleichstromkreis 6 zwischen Gleichrichterkreis 3 und Wechselrichter 7 sich befindet. Die beiden Begriffe "Gleichstromkreis" und "Zwischenkreis" werden nachfolgend synonym verwendet. Der Gleichrichterkreis 3 kann in einem anderen Ausführungsbeispiel durch eine Gleichspannungsquelle ersetzt werden. Der Wechselrichter 7 weist sechs aktive Schalter 8 (S1, S2 und S3) auf, die in diesem Beispiel als Leistungstransistoren ausgebildet sind und die die durch Pulsweiten-Modulation erzeugte Wechselspannung auf die Ausgangsleitungen 9 schalten. Als Strom im Gleichstromkreis 6 wird der Strom betrachtet der dem Zwischenkreiskondensator 4 entnommen und dem Wechselrichter 7 zugeführt wird.

Dieser Strom setzt sich zusammen aus den drei Strangströmen des Wechselrichters, bzw. der angeschlossenen Last. Durch das Steuerverfahren der Puls-Breiten-Modulation (engl.: pulse-width-modulation PWM) ist die Spannung an den Ausgangsleitungen in ihrer Höhe veränderbar. Damit ändert sich auch der Betrag des Zwischenkreisstromes.

Die Zusammensetzung des Zwischenkreisstromes wird durch das Schaltschema der Halbleiterventil (Schalter 7) bestimmt. Die Schaltzustände eine Zweiges der Wechselrichterbrücke sind immer komplementär. Zwischen den beiden Umschaltvorgängen sind beide Ventile kurzzeitig aus. Diese sog. Totzeit schützt die Schaltung vor einem Kurzschluß der Zwischenkreisspannung und ermöglicht den Halbleiterventilen ein sicheres Sperren.

Bei der Belastung des vorliegenden Frequenzumrichters liegen die einzelnen Leiterströme durch die konstruktive Auslegung des Motors und die aufgeprägte PWM-Spannung als Drei-Phasen-Sinusschwingung vor. Zu jedem beliebigen Zeitpunkt addieren sich die drei Teilströme zu einem Gesamtstrom im Gleichstromkreis, wobei das auch einen durch die Freilaufdioden möglichen negativen Stromfluß in den Gleichstromkreis erlaubt. Der Zusammenhang läßt sich durch folgende Rechnung einfach nachvollziehen:

$$I_{Gleichstromkreis} = |(I_{Strang\ 1} + I_{Strang\ 2} + I_{Strang\ 3})|$$

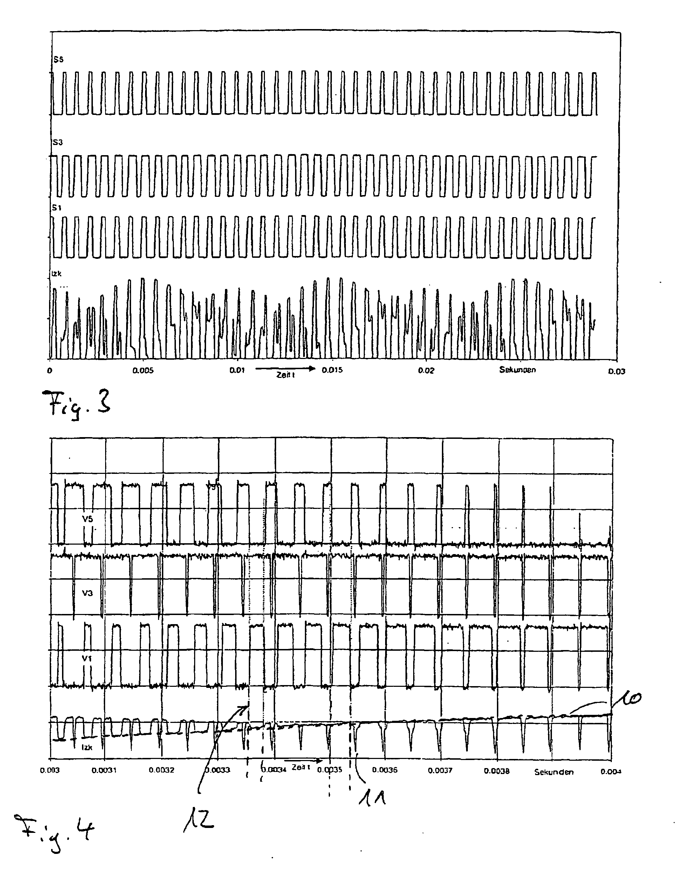

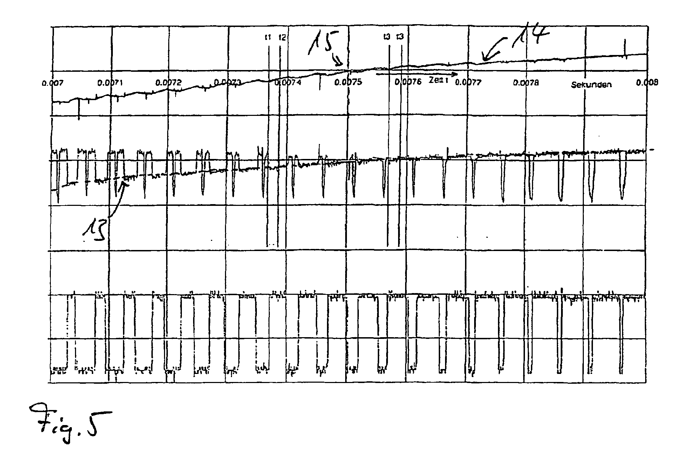

In Figur 2 sind die drei Strangströme (Sinuskurven) und der resultierende Zwischenkreisstrom dargestellt. Figur 3 zeigt nocheinmal einen Zwischenkreisstrom $I_{ZK}$, wie er in Figur 2 dargestellt ist und die Schaltzustände der einzelnen Schalter S1, S3 und S5, die den Zwischenkreisstrom herbeiführen. In Figur 4 ist eine reale Messung des Zwischenkreisstroms $I_{ZK}$ am Shunt zusammen mit den entsprechenden Zuständen der einzelnen Schalter dargestellt. Dabei ist an dem gemessenen Stromverlauf deutlich eine Verlaufscharakteristik 10 (ansteigende Kurve, unterbrochene Linie) zu erkennen, die sich aus dem Strom zwischen den Stromspitzen 11. Diese Verlaufscharakteristik 10 repräsentiert den Strom am Ausgang und kann als Basis für die erfindungsgemäße Regelung herangezogen werden.

Die Puls-Pausen-Verhältnisse der PWM haben direkten Einfluß auf den Strom im Zwischenkreis. Das Puls-Pause-Verhältnis gibt ebenfalls die Zündzeitpunkte der Ventile an. Anhand der gestrichelten Markierung 12 ist zu erkennen, daß die Breite der Impulse unmittelbar in den Zwischenkreisstrom einfließt. Da die Puls-Pausen-Verhältnisse je nach Drehzahl unterschiedlich sind, ergibt sich auch zu jedem Betriebspunkt ein neuer Zusammenhang. In Figur 4 ist als Beispiel die Drehzahl von 4200 min⁻¹ aufgetragen.

Figur 5 zeigt die Zündpulse für einen Schalter, sowie darüberliegend den Verlauf des Zwischenkreisstroms mit seiner eingezeichneten Verlaufscharakteristik 13, sowie den resultierenden Strangstrom 14, der aus der Verlaufscharakteristik des Zwischenkreisstromes, die sich aus dem Strom in den Zwischenphasen zwischen zwei Zündpulsen ergibt, deutlich wird. Deutlich zu erkennen ist auch der Nulldurchgang 15 bei 0.0075 Sekunden.

Aus der "indirekten" Bestimmung des Strangstromes läßt sich der Leistungsfaktor als Kosinus der Phasenverschiebung zwischen Strangstrom und Strangspannung ermitteln, da der Winkel der Spannung wegen der prozessorgesteuerten PWM zu jedem Zeitpunkt bekannt ist. Es seien nachfolgend zwei Ansätze zur Berechnung des Leistungsfaktors dargestellt:

Bei der ersten Lösung handelt es sich um eine Erkennung des Leistungsfaktors anhand der Abbildung der Zündimpulse im Zwischenkreisstrom. Dabei wird der Nulldurchgang im Strangstrom dadurch bestimmt, daß der Zwischenkreisstrom auf den Moment des Sprungs von negativen zu positiven Werten hin untersucht wird (Figur 5). Dieser Ansatz arbeitet mit der direkten Messung der Zündimpulse zu zwei Zeitpunkten. Wie in Fig. 5 ersichtlich, haben die Zündimpulse zum Zeitpunkt t1 und t2 unterschiedliche Amplituden. Diese sind zu den Zeitpunkten t3 im Betrag gleich. Der Phasenstrom eines Stranges hat dort seine Flußrichtung gewechselt, da der Nulldurchgang erreicht wurde. Es ist eine kontinuierliche und schnelle Bestimmung der Phasenlage möglich, da der Phasenwinkel der Spannung durch die prozessorgesteurte PWM jederzeit bekannt ist. Denkbar ist auch eine konkrete Bestimmung des Stromwinkel $\varphi$ zu jedem beliebigen Zeitpunkt t.

Die zweite vorteilhafte Lösung benutzt einen Mittelwertfilter mit Tiefpaßverhalten, um den Sprung im Zwischenkreisstrom zu identifizieren und den Stromwinkel $\varphi$ zu bestimmen. Dabei kann das unverarbeitete Meßsignal mit dem Signal verglichen werden, das den Mittelwertfilter verläßt. Das Signal des Mittelwertfilters gemessen zum Zeitpunkt t2 wird das Signal des Stromes schneiden, wenn der Nulldurchgang erreicht ist. Durch diese Methode kann der Phasenwinkel $\varphi$ des Stromes nicht zu jedem beliebigen Zeitpunkt bestimmt werden. Das Signal des Mittelwertfilters weist zudem zum Signal des Stromes eine Phasenverschiebung auf, die als Meßfehler zu werten ist. Dieser Fehler kann jedoch mittels Microcontroller und Rechnung ausgeglichen werden. Vorteilhaft ist, daß der Mittelwertfilter nur begrenzt auf Lastschwankungen reagiert, die nur kurz vorliegen. Durch derartige Schwankungen kann eine Regelung falsche Werte für die Stellgröße liefern.

## Patentansprüche

1. Verfahren zur einmaligen Ermittlung einer Korrelationsfunktion für die Bestimmung der Amplitude und/ oder der Phase des Stromes am Ausgang eines insbesondere durch einen Synchronmotor belasteten PWM-Umrichterkreises, der einen vor einem Wechselrichter (7) liegenden Gleichstromkreis (6) aufweist, wobei der Wechselrichter (7) mindestens zwei Schalter (S1, S2, S3) aufweist, die in geschlossener Schaltphase den Strom auf eine Ausgangsleitung (9) durchschalten,
wobei,

   - der Strom im Gleichstromkreis (6) über einen mehrere Schaltphasen umfassenden Zeitraum gemessen und registriert wird,
   - aus dem registrierten Stromverlauf, insbesondere aus der Änderung des Stromes zwischen den Schaltphasen, eine Verlaufscharakteristik (10) durch eine Filterung des registrierten Stromverlaufs abgeleitet wird, und
   - aus der Verlaufscharakteristik (10) und dem tatsächlichen Ausgangsstrom eine Korrelationsfunktion ermittelt wird, über die der Strom am Ausgang (9) bestimmbar ist, wobei die Korrelationsfunktion den Zusammenhang zwischen dem Meßwert des Stromes im Gleichstromkreis (6) und dem zu errechnenden Strom am Ausgang (9) darstellt.

2. Verfahren nach Anspruch 1,
   **dadurch gekennzeichnet, daß** die Korrelationsfunktion in einem digitalen Speicher gespeichert wird.

3. Verfahren nach Anspruch 2,
   **dadurch gekennzeichnet, daß** der Strom im Gleichstromkreis (6) während des Betriebes des PWM-Umrichterkreises im Intervall zwischen zwei PWM-Pulsen gemessen wird und daß aus dem aktuellen Meßwert über die Korrelationsfunktion auf den Strom am Ausgang (9) geschlossen wird.

4. Verfahren nach Anspruch 1 oder 2,
   **dadurch gekennzeichnet, daß** der Strom am Ausgang (9) während des Betriebes des PWM-Umrichterkreises kontinuierlich durch Messung des Stromes im Gleichstromkreis (6) bestimmt wird, wobei aus der Messung unter Berücksichtigung der Korrelationsfunktion insbesondere auf die Phasenlage des Ausgangsstromes geschlossen wird.

5. Verfahren nach einem der vorherigen Ansprüche,
   **dadurch gekennzeichnet, daß** der Leistungsfaktor im Ausgangskreis aus der Verlaufscharakteristik (10) bestimmt wird.

**6.** Verfahren nach einem der vorherigen Ansprüche, **dadurch gekennzeichnet, daß**, der Nulldurchgang des Stromes im Ausgangskreis aus der Verlaufscharakteristik (10) bestimmt wird.

**7.** Verfahren nach einem der vorherigen Ansprüche, **dadurch gekennzeichnet, daß** der Strom über einem Shunt (5) im Gleichstromkreis (6) gemessen wird.

**8.** Verfahren nach einem der vorherigen Ansprüche, **dadurch gekennzeichnet, daß** der Stromverlauf mittels eines Band passes gefiltert und der gefilterte Stromverlauf der Verlaufscharakteristik(10) gleichgesetzt wird.

**9.** Verfahren nach einem der vorherigen Ansprüche, **dadurch gekennzeichnet, daß** die Meßwerte über einen ADC in digitale Werte umgewandelt und in einem Speicher registriert werden.

**10.** Verfahren nach Anspruch 9, **dadurch gekennzeichnet, daß** aus dem Stromverlauf mittels einer rechnerischen Filterfunktion, insbesondere mittels eines Mittelwertfilters, die Verlaufscharakteristik (10) bestimmt wird.

**11.** Einsatz des Verfahrens nach einem der vorherigen Ansprüche zur Leistungsfaktorregelung eines Elektromotors, insbesondere eines permanenterregten Synchronmotors, mit einem eine Statorwicklung aufweisenden Stator und mit einem Rotor, wobei die Statorwicklung über eine Ausgangsleitung eines PWM-Umrichterkreises versorgt wird, **dadurch gekennzeichnet,**

- **daß** eine Abhängigkeit zwischen den durch Drehzahl und/oder Belastung definierten Betriebspunkten und der entsprechenden Phasenverschiebung ermittelt und der ermittelte funktionale Zusammenhang in einem der Regelung zur Verfügung stehenden Speicher niedergelegt wird, wobei sich aus der Abhängigkeit für jeden Betriebspunkt ein Sollwert für den Nulldurchgang des Ausgangsstromes ergibt,
- **daß** im Rahmen der Regelung die aktuelle Drehzahl ermittelt und anhand der gemessenen Verlaufscharakteristik des Stromes im Gleichstromkreis der Istwert des Nulldurchgangs des Ausgangsstromes bestimmt wird und
- **daß** die Amplitude der Wechselspannung verändert wird zur Angleichung des Istwerts und des aus der gespeicherten Abhängigkeit bekannten Sollwerts des Nulldurchgangs.

**12.** Einsatz nach Anspruch 11, **dadurch gekennzeichnet, daß** Grenzwerte vorgegeben werden, innerhalb derer sich die ermittelte Stromstärke befinden muß, wobei die Ansteuerung ausgesetzt wird, wenn die ermittelte Stromstärke die Grenzwerte überschreitet.

**13.** Einsatz nach Anspruch 11 oder 12, **dadurch gekennzeichnet, daß** die Abhängigkeit zwischen Drehzahl und Phasenverschiebung vom Hersteller für einen bestimmten Motortyp ermittelt und als Wertetabelle oder Funktion gespeichert wird.

**14.** Einsatz nach einem der vorherigen Ansprüche 11 bis 13, **dadurch gekennzeichnet, daß** der Elektromotor ein sensorloser elektronisch kommutierter Synchronmotor ist.

**Claims**

**1.** Method of a single determination of a correlation function for determining the amplitude and/or phase of the current at the output of a pulse-width-modulated frequency converter circuit loaded in particular by a synchronous motor, said frequency converter having a direct-current circuit (6) upstream of a d.c.-a.c. converter (7) and the d.c.-a.c. converter (7) having at least two switches (S1, S2, S3) which, in the closed switching phase, switch the current through to an output line (9), **where**

- the current in the direct-current circuit (6) is measured and registered over a period of time involving a plurality of switching phases,
- a pattern characteristic (10) is derived from the registered current path, in particular from the change in the current between switching phases, by filtering the registered current path, and
- from the pattern characteristic (10) and the actual output current a correlation function is established by way of which the current at the output (9) can be determined, the correlation function representing the interrelationship between the measured value of the current in the direct-current circuit (6) and the current to be calculated at the output (9).

**2.** Method according to Claim 1, **characterized in that** the correlation function is stored in a digital memory.

**3.** Method according to Claim 2, **characterized in that**, during operation of the pulse-width-modulated frequency converter circuit, the current in the direct-current circuit (6) is measured in the interval between two pulse-width-modulated pulses, **and in that** the current at the output (9) is deduced from the actual measured value by way of the correlation function.

**4.** Method according to Claim 1 or 2,
**characterized in that**
the current at the output (9) is continuously determined during operation of the pulse-width-modulated frequency converter circuit by measuring the current in the direct-current circuit (6), the phase position in particular of the output current being deduced from said measurement taking into account the correlation function.

**5.** Method according to one of the preceding claims,
**characterized in that**
the power factor in the output circuit is determined from the pattern characteristic (10).

**6.** Method according to one of the preceding claims,
**characterized in that**
the zero crossing of the current in the output circuit is determined from the pattern characteristic (10).

**7.** Method according to one of the preceding claims,
**characterized in that**
the current is measured by way of a shunt (5) in the direct-current circuit (6).

**8.** Method according to one of the preceding claims,
**characterized in that**
the current path is filtered by means of a band-pass filter and the filtered current path is equated with the pattern characteristic (10).

**9.** Method according to one of the preceding claims,
**characterized in that**
the measured values are converted by means of an analogue-digital converter into digital values and registered in a memory.

**10.** Method according to Claim 9,
**characterized in that**
the pattern characteristic (10) is determined from the current path by means of a mathematical filter function, in particular by means of a mean-value filter.

**11.** Use of the method according to one of the preceding claims for the power-factor control of an electric motor, in particular a permanently excited synchronous motor, with a stator having a stator winding and with a rotor, the stator winding being supplied via an output line of a pulse-width-modulated frequency converter circuit,
**characterized in that**

- a dependence is established between the operating points, defined by speed and/or load, and the corresponding phase shift, and the determined functional interrelationship is deposited in a memory available to the control, a desired value for the zero crossing of the output current resulting from the dependence for each operating point,
- **in that** within the limits of the control the actual speed is determined, and the actual value of the zero crossing of the output current is determined with the aid of the measured pattern characteristic of the current in the direct-current circuit, **and**
- **in that** the amplitude of the alternating-current voltage is changed for the purpose of bringing into line the actual value and the desired value of the zero crossing known from the stored dependence.

**12.** Use according to Claim 11,
**characterized in that**
limiting values are preset, within which the determined current intensity must lie, the control being interrupted when the determined current intensity exceeds the limiting values.

**13.** Use according to Claims 11 or 12,
**characterized in that**
the dependence between speed and phase shift is established by the manufacturer for a specific motor type and is stored as a table of values or a function.

**14.** Use according to one of the preceding claims 11 to 13,
**characterized in that**
the electric motor is a sensor-less electronically commutated synchronous motor.

**Revendications**

**1.** Procédé pour une seule détermination d'une fonction de corrélation pour la détermination de l'amplitude et/ou de la phase du courant à la sortie d'un circuit changeur de fréquence à modulation d'impulsions en largeur, en particulier chargé par un moteur synchrone, qui présente un circuit de courant continu (6) se trouvant avant un onduleur (7), l'onduleur (7) présentant au moins deux commutateurs (S1,S2,S3) qui couplent le courant en phase de commutation fermée sur une ligne de sortie (9), moyennant quoi

- le courant dans le circuit de courant continu (6) est mesuré et enregistré sur un intervalle de temps comprenant plusieurs phases de commutation,
- une caractéristique d'allure (10) est dérivée de l'allure de courant enregistrée, en particulier de la modification du courant entre les phases de commutation, par une filtration de l'allure de courant enregistrée et
- une fonction de corrélation est déterminée à partir de la caractéristique d'allure (10) et le courant de sortie réel, par laquelle le courant à la sortie (9) peut être déterminé, la fonction de corrélation représentant le rapport entre le la valeur mesurée du courant dans le circuit de courant continu (6) et le courant à attendre à la sortie (9).

2. Procédé selon la revendication 1,
**caractérisé par le fait que** la fonction de corrélation est mémorisée dans une mémoire numérique.

3. Procédé selon la revendication 2,
**caractérisé par le fait que** le courant dans le circuit de courant continu (6) est mesuré pendant le fonctionnement du circuit changeur de fréquence à modulation d'impulsions en largeur dans l'intervalle de deux impulsions de modulation d'impulsions en largeur et qu'on arrête sur le courant à la sortie (9) par l'intermédiaire de la fonction de corrélation à partir de la valeur de mesure effective.

4. Procédé selon la revendication 1 ou 2,
**caractérisé par le fait que** le courant à la sortie (9) est déterminé en continu pendant le fonctionnement du circuit changeur de fréquence à modulation d'impulsions en largeur par mesure du courant dans le circuit de courant continu (6), de la mesure avec prise en compte de la fonction de corrélation étant en particulier arrêté sur la position de phase du courant de sortie.

5. Procédé selon l'une des revendications précédentes,
**caractérisé par le fait que** le facteur de puissance dans le circuit de sortie est déterminé à partir de la caractéristique d'allure (10).

6. Procédé selon l'une des revendications précédentes,
**caractérisé par le fait que** le passage par zéro du courant dans le circuit de sortie est déterminé à partir de la caractéristique d'allure (10).

7. Procédé selon l'une des revendications précédentes,
**caractérisé par le fait que** le courant est mesuré dans le circuit de courant continu (6) par l'intermédiaire d'un shunt (5).

8. Procédé selon l'une des revendications précédentes,
**caractérisé par le fait que** l'allure de courant est filtrée au moyen d'un passe-bande et l'allure de courant filtrée est égalée à la caractéristique d'allure (10).

9. Procédé selon l'une des revendications précédentes,

**caractérisé par le fait que** les valeurs de mesure sont transformées en valeurs numériques par l'intermédiaire d'un convertisseur analogique numérique et enregistrées dans une mémoire.

10. Procédé selon la revendication 9,
**caractérisé par le fait que** la caractéristique d'allure (10) est déterminée à partir de l'allure de courant au moyen d'une fonction filtre mathématique, en particulier au moyen d'un filtre de valeurs moyennes.

11. Mise en oeuvre du procédé selon l'une des revendications précédentes pour la régulation du facteur de puissance d'un moteur électrique, en particulier d'un moteur synchrone à excitation permanente, avec un stator présentant un bobinage statorique et avec un rotor, le bobinage statorique étant alimenté par l'intermédiaire d'une ligne de sortie d'un circuit changeur de fréquence à modulation d'impulsions en largeur,
**caractérisée par le fait**

- **qu'**une relation est déterminée entre les points de fonctionnement dynamique définis par la vitesse de rotation et/ou la charge et le décalage de phases correspondant et la relation fonctionnelle déterminée est fixée à une mémoire qui est à la disposition de la régulation, une valeur de consigne pour le passage par zéro du courant de sortie résultant de la relation pour chaque point de fonctionnement,
- **que** la vitesse de rotation instantanée est déterminée dans le cadre de la régulation et la valeur instantanée du passage par zéro du courant de sortie est déterminée à l'aide de la caractéristique d'allure mesurée du courant dans le circuit de courant continu et
- **que** l'amplitude de la tension alternative est modifiée pour la compensation de la valeur instantanée et de la valeur de consigne du passage par zéro connue la dépendance mémorisée.

12. Mise en oeuvre selon la revendication 11,
**caractérisée par le fait que** des valeurs limites sont prédéfinies à l'intérieur desquelles l'intensité de courant déterminée doit se trouver, la commande étant arrêtée lorsque l'intensité de courant déterminée dépasse les valeurs limites.

13. Mise en oeuvre selon la revendication 11 ou 12,
**caractérisée par le fait que** la dépendance entre la vitesse de rotation et le décalage de phases est déterminée par le fabricant pour un type de moteur déterminé et est mise en mémoire en tant que table de valeurs ou fonction.

14. Mise en oeuvre selon l'une des revendications 11 à 13 précédentes,

**caractérisée par le fait que** le moteur électrique est un moteur synchrone commute électroniquement sans capteur.

Fig. 1

Frequenz 50 Hz
PWM-Frequenz 500 Hz
Zeitauflösung 50µs

Fig. 2

Fig. 3

Fig. 4

Fig. 5

12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3540182 A1

**In der Beschreibung aufgeführte Nicht-Patentliteratur**

- **GREEN, T. C et al.** Derivation of motor line-current waveforms from the DC-link current of an inverter. *IEE PROCEEDINGS B (ELECTRIC POWER APPLICATIONS,* Juli 1989, vol. 136 (4), 196-204